Europäisches Patentamt

(19) European Patent Office

Office européen des brevets

(11) Publication number: **0 181 658**
**B1**

(12) EUROPEAN PATENT SPECIFICATION

(45) Date of publication of patent specification: 27.06.90

(51) Int. Cl.⁵: **H 04 N 5/12**, H 03 L 7/14

(21) Application number: 85201670.8

(22) Date of filing: 11.10.85

(54) Synchronizing circuit for an oscillator.

(30) Priority: 16.10.84 NL 8403149

(43) Date of publication of application:
21.05.86 Bulletin 86/21

(45) Publication of the grant of the patent:
27.06.90 Bulletin 90/26

(84) Designated Contracting States:
DE FR GB IT NL

(56) References cited:
FR-A-2 356 309
US-A-3 882 412

(73) Proprietor: N.V. Philips' Gloeilampenfabrieken
Groenewoudseweg 1
NL-5621 BA Eindhoven (NL)

(72) Inventor: van Raalte, Steven Jan
c/o INT. OCTROOIBUREAU B.V. Prof. Holstlaan 6
NL-5656 AA Eindhoven (NL)

(74) Representative: van Gils, Cornelis Johannes
Maria et al
INTERNATIONAAL OCTROOIBUREAU B.V. Prof.
Holstlaan 6
NL-5656 AA Eindhoven (NL)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to a method of initially adjusting a synchronizing circuit, said circuit comprising: a controllable oscillator, a phase discriminator having a signal input for receiving an incoming synchronizing signal during normal operation, an input for receiving a signal generated by the oscillator and an output for producing a signal which depends on a phase difference between the received signals, a loop filter for smoothing the signal at the output of the phase discriminator and for applying a control signal to a control signal input of the oscillator for controlling the frequency and the phase of the signal generated thereby, the said elements being part of a control loop having in operation a pull-in range, a comparator for comparing said control signal with a reference value, a logic circuit for receiving information from the comparator, a store for storing information from the logic circuit and a digital-to-analog converter for converting information from the store into a signal and for applying this signal to the control input of the oscillator; said method comprising the steps of: applying a signal to the signal input of the phase discriminator, which signal has a frequency located in the vicinity of the frequency of the incoming synchronizing signal, giving an initial value to the signal applied by the digital-to-analog converter to the control input of the oscillator and changing the value of said signal stepwise.

Such a method is known from the United States Patent US—A—4,107,623, the purpose of the prior art circuit therein being to synchronize an oscillator with a very stable generator. The circuit comprises an analog and a digital control loop both producing a control signal for the oscillator. During the initial adjustment procedure, a counter which is part of the digital control loop assumes a value such that the signal obtained from digital-to-analog conversion of this value is equal to the analog control value obtained by means of the analog control loop. In normal operation the digital control loop is the main control means for controlling the oscillator, the counter value being repeatedly readjusted, while the gain of the analog control loop is reduced to 1% of its initial value this providing a fine control.

A method of the type set forth above is according to the invention characterised in that for initially adjusting a line synchronizing circuit for a picture display device the signal applied to the signal input of the phase discriminator has a frequency located in the vicinity of the repetition frequency of line synchronizing pulses contained in the incoming synchronizing signal, the initial value of the signal applied to the control input of the oscillator corresponding to an extreme frequency of the pull-in range of the control loop, the value of said signal being changed under the control of the logic circuit from said initial value until the control signal is substantially equal to the reference value applied to the comparator, which ends the step of changing the signal value, a word value from the logic circuit corresponding to the signal value obtained being then entered into the store.

The invention is based on the idea that a line synchronizing circuit for a picture display device need not be as accurate as the known circuit, while the frequency and the phase of the incoming signal may be subject to variations. The method in accordance with the invention implicates that the digital part of the circuit is provided to be only operative during the initial adjustment, more specifically for storing the word which corresponds to a given frequency located in the vicinity of the line frequency. On switch-on of the picture display device the oscillator immediately assumes this frequency, so that there can be no large deviation between the actual frequency and the target value thereof before a control signal is built-up. Such a deviation is undesirable, as a line output transistor whose drive signal is supplied by the line oscillator, might be damaged thereby. If no incoming line synchronizing signal is present, then the oscillator has substantially the normal frequency, so that the output transistor is protected. In normal operation, only the analog control loop is operative for continuously controlling the oscillator, information from this control loop being superimposed on the adjustment value produced by the digital-to-analog converter from the signal value stored in the store, by which control it is ensured that the oscillator is capable of following any variation of the incoming signal within the pull-in range of the control loop.

The invention also relates to a line synchronizing circuit for a picture display device, said circuit being initially adjusted according to the above method and comprising: a controllable oscillator, a phase discriminator having a signal input for, during normal operation, receiving an incoming synchronized signal, an input for receiving a signal generated by the oscillator and an output for producing a signal which depends on a phase difference between the received signals, a loop filter for smoothing the signal at the output of the phase discriminator and for applying a control signal to a control signal input of the oscillator for controlling the frequency and the phase of the signal generated thereby, the said elements being part of an analog control loop having in operation a pull-in range, a comparator for comparing said control signal with a reference value, a logic circuit for receiving information from the comparator, a store for storing information from the logic circuit and a digital-to-analog converter for converting information from the store into a signal and for applying this signal to the control input of the oscillator, said circuit being characterised in that during normal operation a substantially constant word value stored in the store corresponds, after digital-to-analog conversion, to a central frequency located approximately halfway the pull-in range of the analog control loop.

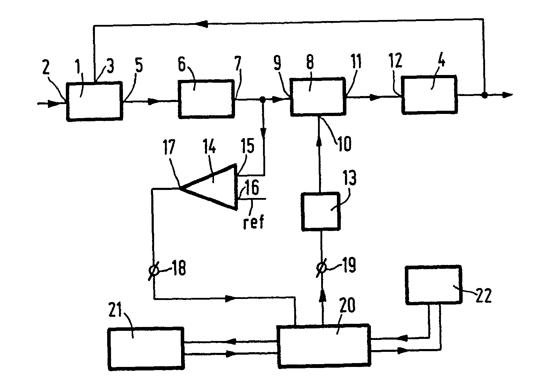

The invention will be described in greater detail by way of example with reference to the accompanying drawing, which illustrates a portion of a picture display device, for example a television receiver, comprising a synchronizing circuit in accordance with the invention.

In the Figure, reference numeral 1 denotes a phase discriminator. An incoming line syncrhonizing signal which is obtained from, for example, a synchronization separator is applied to a signal input 2 of the phase discriminator, and a signal generated by a line oscillator 4 to an input 3 of this discriminator 1. In operation, a voltage whose value depends on the phase difference between the two signals is present at an output 5 of the discriminator 1. Discriminator 1 is implemented in known manner such that its output voltage assumes a value which may be positive or negative. This voltage is smoothed by a loop filter 6. The output 7 of the filter 6 is connected to a first input 9 of an adder stage 8 an output 11 of which is connected to a control signal input 12 of oscillator 4. The output of a digital-to-analog converter 13 is connected to a second input 10 of adder stage 8. A control voltage which is the sum of the voltage supplied by filter 6 and converter 13 is present at output 11. Oscillator 4 is controlled by the control voltage, more specifically such that the oscillator signal is substantially in synchronism with the line synchronizing signal applied to input 2. The oscillator signal is applied to stages, not shown, in which it is further processed for the horizontal deflection in a picture display tube.

The output 7 of filter 6 is also connected to a first input 15 of a comparator stage 14, a second input 16 of which is connected to a reference voltage. An output 17 of stage 14 is connected to a connecting terminal 18 of an integrated circuit referred to above which comprises the greater part of the different components of the present synchronizing circuit. The input of converter 13 is connected to a connecting terminal 19 of the integrated circuit. Advantageously, terminals 18 and 19 may be connected to a terminal of a serial two-wire $I^2C$-bus which interconnects the different integrated circuits of the picture display device. Terminals 18 and 19 are connected thereby to a logic circuit 20.

The synchronizing circuit is automatically adjusted as follows. At input 2 a signal is applied which has the desired central frequency $f_c$, i.e. a frequency which is chosen for an optimum hold- and pull-in range of the phase control loop formed by elements 1, 4, 6 and 8, and which is located approximately halfway this range in the vicinity of the nominal repetition frequency of the applied line synchronization pulses. For oscillator 4 a control voltage $V_c$ corresponds to frequency $f_c$. The value of the reference voltage at input 16 is equal in this example to zero. Circuit 20 comprises a microprocessor which is controlled during the adjusting procedure by an adjustment computer 21. Computer 21 provides for a plurality of adjustments in the picture display device. The microprocessor step-wise changes the word value of converter 13 from a predetermined value. The initial value corresponds to an extreme frequency of the pull-in range of the control loop. In addition, circuit 20 comprises a counter which is enabled when the adjusting program is started and which each time applies a signal to converter 13. A given voltage at input 10 corresponds to each position of the counter. The counting function can alternatively be effected by computer 21, in that the memory of the computer supplies the counting position, which counting position is thereafter increased or decreased incrementally. Because of the operation of the control loop, the signal of oscillator 4 has always substantially the central frequency $f_c$ of the applied input signal, so that the control voltage at input 12 has always substantially the value $V_c$. This implies that at each change of the word value of converter 13 the voltage at the output 7 of filter 6 assumes a different value.

At the instant at which the voltage at output 7 becomes substantially equal to zero, comparator stage 14 switches, causing an information to be conveyed to computer 21 for ending the counting operation, whilst the achieved word value is stored in a store 22, for example a $E^2$PROM (electrically erasable programmable read-only memory). In this situation, the microprocessor in circuit 20 may be the microprocessor which provides for a plurality of controls, for example for a search tuning system in a television receiver, whilst a number of adjustment data are stored in store 22, for example relating to preset transmitters, it being possible, for example after repair operations to the receiver, to replace these data by other data. Both circuit 20 and store 22 are incorporated in the picture display device, whilst computer 21 is an adjustment computer for automatically adjusting during manufacture in accordance with a predetermined procedure a plurality of circuits in a plurality of picture display devices. The procedure outlined above accomplishes that a word value which corresponds to the central frequency of oscillator 4 is stored in store 22, whilst the tolerances of all the components of the line phase control loop are taken into account. This adjustment is effected without the loop being opened, for example by interrupting the connection between filter 6 and oscillator 4. The accuracy of the adjustment depends on the input threshold voltage (offset) of comparator stage 14, on the accuracy with which voltage $V_c$ is known and on the resolution of converter 13. In a practical embodiment of the invention an accuracy of approximately 50 Hz was reached at a pull-in range of approximately 1 kHz on both sides of the nominal line frequency, which is 15.625 kHz.

Each time the picture display device is switched on, the word read from store 22 is conveyed by circuit 20 to digital-to-analog converter 13, so that oscillator 4 oscillates already at the central frequency before the line phase control loop is operataive, as the constant voltage required therefor is present at the second input 10 of adding stage 8, whilst no voltage is yet present at the first input 9. Shortly after switch-on, the control voltage is built-up for continuously locking the oscillator signal on the frequency and the phase of the incoming line synchronizing signal, which control voltage is the sum of the, usually variable, voltage supplied by filter 6 and of the constant voltage supplied by converter 13.

It will be noted that the described line synchronizing circuit, and also the control means therefor, comprise prior art components which need not be further described and which are not critical. Oscillator 4 may be constructed as a two-level sawtooth oscillator, one of the levels and consequently the frequency being controllable by a voltage or by current, for example the charge or discharging current of a sawtooth capacitor. Oscillator 4 and stage 8 can be constructed such that one of the levels is adjustable by the filter and one of the slopes of the sawtooth shape by the computer, or *vice verse.* In that case, in which the control signal from the control loop and the reference signal supplied by converter 13 act differently upon oscillator 4, stage 8 is no adder stage but a combination stage for superimposing both informations. Alternatively, oscillator 4 may be replaced by a generator formed by an oscillator, which oscillator has the chrominance subcarrier frequency or a multiple thereof, and a frequency-dividing circuit for dividing this frequency by a variable divider. The frequency of the signal applied to input 2 during the adjustment procedure and the voltage applied to input 16 may have values other than those in the foregoing. This voltage is determined during the design of the circuit and can be derived in a simple way from the supply voltage with the aid of resistors.

**Claims**

1. A method of initially adjusting a synchronizing circuit, said circuit comprising: a controllable oscillator, a phase discriminator having a signal input for receiving an incoming synchronized signal during normal operation, an input for receiving a signal generated by the oscillator and an output for producing a signal which depends on a phase difference between the received signals, a loop filter for smoothing the signal at the output of the phase discriminator and for applying a control signal to a control signal input of the oscillator for controlling the frequency and the phase of the signal generated thereby, the said elements being part of a control loop having in operation a pull-in range, a comparator for comparing said control signal with a reference value, a logic circuit for receiving information from the comparator, a store for storing information from the logic circuit and a digital-to-analog converter for converting information from the store into a signal and for applying this signal to the control input of the oscillator; said method comprising the steps of: applying a signal to the signal input of the phase discriminator, which signal has a frequency located in the vicinity of the frequency of the incoming synchronizing signal, giving an initial value to the signal applied by the digital-to-analog converter to the control input of the oscillator and changing the value of said signal stepwise; and being characterised in that for initially adjusting a line synchronizing circuit for a picture display device the signal applied to the signal input of the phase discriminator has a frequency located in the vicinity of the repetition frequency of line synchronizing pulses contained in the incoming synchronizing signal, the initial value of the signal applied to the control input of the oscillator corresponding to an extreme frequency of the pull-in range of the control loop, the value of said signal being changed under the control of the logic circuit from said initial value until the control signal is substantially equal to the reference value applied to the comparator, which ends the step of changing the signal value, a word value from the logic circuit corresponding to the signal value obtained being then entered into the store.

2. A line synchronizing circuit suitable for a picture display device, said circuit being initially adjusted according to the method claimed in Claim 1 and comprising: a controllable oscillator, a phase discriminator having a signal input for, during normal operation, receiving an incoming synchronizing signal, an input for receiving a signal generated by the oscillator and an input for producing a signal which depends on a phase difference between the received signals, a loop filter for smoothing the signal at the output of the phase discriminator and for applying a control signal to a control signal input of the oscillator for controlling the frequency and the phase of the signal generated thereby, the said elements being part of an analog control loop having in operation a pull-in range, a comparator for comparing said control signal with a reference value, a logic circuit for receiving information from the comparator, a store for storing information from the logic circuit and a digital-to-analog converter for converting information from the store into a signal and for applying this signal to the control input of the oscillator; said circuit being characterised in that during normal operation a substantially constant word value stored in the store corresponds, after digital-to-analog conversion, to a central frequency located approximately halfway the pull-in range of the analog control loop.

3. A line synchronizing circuit as claimed in Claim 2, characterised in that during normal operation the word value stored in the store is transferred by the logic circuit to the digital-to-analog converter.

4. A line synchronizing circuit as claimed in Claim 2, characterised in that the logic circuit has a counting function during the initial adjustment procedure.

5. A line synchronizing circuit as claimed in Claim 2, characterised in that the store is an $E^2PROM$.

## Patentansprüche

1. Verfahren zum einleitenden Einstellen einer Synchronisationsschaltung, die folgende Elemente enthält: einen steurbaren Oszillator, einen Phasendiskriminator mit einem Signaleingang zum Empfangen eines ankommenden Synchronisationssignals im Normalbetrieb, einen Eingang zum Empfangen eines im Oszillator erzeugten Signals und einen Ausgang zum Ausgeben eines von einem Phasenunterschied zwischen den empfangen Signalen abhängigen Signals, ein Schleifenfilter zum Glätten des Signals am Ausgang des Phasendiskriminators und zum Zuleiten eines Steuersignals zu einem Steuersignaleingang des Oszillators zum Steuern der Frequenz und der Phase des dabei erzeugten Signals, wobei diese Elemente Teile einer Steuerschleife mit einem in Betrieb wirksamen Synchronisationsbereich sind, einen Komparator zum Vergleichen des Steursignals mit einem Bezugswert, eine Logikschaltung zum Empfangen von Information aus dem Komparator, einen Speicher zum Einschreiben von Information aus der Logikschaltung und einen Digital/Analog-Wandler zum Umsetzen von Information aus dem Speicher in ein Signal und zum Zuleiten dieses Signals zum Steuereingang des Oszillators, wobei dieses Verfahren folgende Schritte umfaßt: Zuführen eines Signals zum Signaleingang des Phasendiskriminators, wobei die Signalfrequenz unweit von der Frequenz des ankommenden Synchronisationssignals liegt; Zuweisen eines Anfangswerts zu dem dem Steuereingang des Oszillators durch den D/A-Wandler zugleiteten Signals und gestuftes Andern des Wertes dieses Signals, dadurch gekennzeichnet, daß zum einleitenden Einstellen einer Horizontalsynchronisationsschaltung für ein Bildwiedergabegerät die Frequenz des an den Signaleingang des Phasendiskriminators gelangenden Signals unweit von der Wiederholungsfrequenz von Horizontalsynchronisationsimpulsen im ankommenden Synchronisationssignal liegt, der Anfangswert des an den Steuereingang des Oszillators gelegten Signals eine Außenfrequenz des Synchronisationsbereichs in der Steuerschleife entspricht, der Wert des Signals unter der Steuerung der Logikschaltung vom genannten Anfangswert dahingehend geändert wird, daß das Steuersignal im wesentlichen gleich dem an den Komparator gelegten Bezugswert ist, wodurch der Anderungsschritt für den Signalwert beendet und darauf ein Wortwert aus der Logikschaltung entsprechend dem empfangenen Signalwert in den Speicher eingeschrieben wird.

2. Horizontalsynchronisationsschaltung für ein Bildwiedergebegerät, die entsprechend dem Verfahren nach Anspruch 1 einleitend eingestellt wird und einen steuerbaren Oszillator, einen Phasendiskriminator mit einem Signaleingang zum Empfangen eines im Normalbetrieb ankommenden Synchronisationssignals, einen Eingang zum Empfangen eines im Oszillator erzeugten Signals und einen Ausgang zum Ausgeben eines von einem Phasenunterschied zwischen den empfangenen Signalen abhängigen Signals, ein Schleifenfilter zum Glätten des Signals am Ausgang des Phasendiskriminators und zum Zuleiten eines Steuersignals zu einem Steuersignaleingang des Oszillators zum Steuern der Frequenz und der Phase des dabei erzeugten Signals, wobei diese Elemente Teile einer analogen Steuerschleife mit einem im Betrieb wirksamen Synchronisationsbereich sind, einen Komparator zum Vergleichen des Steuersignals mit einem Bezugswert, eine Logikschaltung zum Emfangen von Information aus dem Komparator, einen Speicher zum Einschreiben von Information aus der Logikschaltung und einen Digital/Analog-Wandler zum Umsetzen von Information aus dem Speicher in ein Signal und zum Zuleiten dieses Signals zum Steuereingang des Oszillators enthält, dadurch gekennzeichnet, daß im Normalbetrieb ein im wesentlichen konstanter und im Speicher gespeicherter Wortwert nach der D/A-Wandlung einer Mittenfrequenz entspricht, die etwa halbwegs des Synchronisationsbereichs der analogen Steuerschleife liegt.

3. Horizontalsynchronisationsschaltung nach Anspruch 2, dadurch gekennzeichnet, daß im Normalbetrieb der im Speicher gespeicherte Wortwert von der Logikschaltung auf den D/A-Wandler übertragen wird.

4. Horizontalsynchronisationsschaltung nach Anspruch 2, dadurch gekennzeichnet, daß die Logikschaltung für die Dauer des einleitenden Einstellverfahrens eine Zählfunktion hat.

5. Horizontalsynchronisationsschaltung nach Anspruch 2, dadurch gekennzeichnet, daß der Speicher ein $E^2$PROM-Speicher ist.

## Revendications

1. Procédé d'adjustement initial d'un circuit de synchronisation, ledit circuit comportant: un oscillateur réglable, un discriminateur de phase muni d'une entrée de signal pour recevoir au cours du fonctionnement normal un signal de synchronisation incident, d'une entrée pour recevoir un signal engendré par l'oscillateur et d'une sortie pour fournir un signal dépendant d'une différence de phase entre les signaux recus, un filtre de boucle pour niveler le signal sur la sortie du discriminateur de phase et pour appliquer un signal de réglage à une entrée de signal de réglage de l'oscillateur pour régler la fréquence et la phase du signal engendré par celui-ci, lesdits éléments faisant partie d'une boucle de réglage ayant un domaine d'accrochage au cours du fonctionnement, un comparateur pour comparer ledit signal de réglage avec une valeur de référence, un circuit logique pour recevoir de l'information à partir du comparateur, une mémoire pour stocker de l'information du circuit logique et un convertisseur numérique-analogique pour convertir en un signal de l'information provenant de la mèmoire de pour appliquer ce signal à l'entrée de réglage de l'oscillateur; ledit procédé comportant les étapes consistant: à appliquer un signal à l'entrée de signal du discriminateur de phase, signal qui a une fréquence voisine de la fréquence du signal de synchronisation incident, à donner une valeur initiale au signal appliqué par le convertisseur numérique-analogique à l'entrée de réglage de l'oscillateur et à modifier par étapes la valeur dudit signal; et étant caractérisé en ce que pour l'ajustement initial d'un circuit de synchronisation de ligne destiné à un dispositif de reproduction d'images, le signal appliqué à l'entrée de signal du discriminateur de phase a une fréquence voisine de la fréquence de répétition d'impulsions de synchronisation de ligne contenues dans le signal de synchronisation incident, la valeur initiale du signal appliqué à l'entrée de réglage de l'oscillateur correspondant à une fréquence extrême du domaine d'accrochage de la boucle de réglage et la valeur dudit signal étant modifiée à partir de ladite valeur initiale sous la commande du circuit logique jusqu'à ce que le signal de réglage soit sensiblement égal à la valeur de référence appliquée au comparateur, ce qui termine l'étape de modification de la valeur de signal, après quoi une valeur de mot issue du circuit logique et correspondant à la valeur de signal obtenue est introduite dans la mémoire.

2. Circuit de synchronisation de ligne convenant pour un dispositif de reproduction d'images ledit circuit étant soumis à un ajustement initial selon le procédé ci-dessus et comportant: un oscillateur réglable, un discriminateur de phase muni d'une entrée de signal pour recevoir au cours du fonctionnement normal un signal de synchronisation incident, d'une entrée pour recevoir un signal engendré par l'oscillateur de d'une sortie pour fournir un signal dépendant d'une différence de phase entre les signaux reçus, un filtre de boucle pour niveler le signal sur la sortie du discriminateur de phase et pour appliquer un signal de réglage à une entrée de signal de réglage de l'oscillateur pour régler la fréquence et la phase du signal engendré par celui-ci, lesdits éléments faisant partie d'une boucle de réglage analogique ayant un domaine d'accrochage au cours du fonctionnement, un comparateur pour comparer ledit signal de réglage avec une valeur de référence, un circuit logique pour recevoir de l'information à partir du comparateur, une mémoire pour stocker de l'information du circuit logique et un convertisseur numérique-analogique pour convertir en un signal de l'information provenant de la mémoire et pour appliquer ce signal à l'entrée de réglage de l'oscillateur; ledit circuit étant caractérisé en ce que, au cours du fonctionnement normal, une valeur de mot sensiblement constante stockée dans la mémoire correspond, après conversion numérique-analogique, à une fréquence centrale située à peu près au milieu du domaine d'accrochage de la boucle de réglage analogique.

3. Circuit de synchronisation de ligne selon la revendication 2, caractérisé en ce que, au cours du fonctionnement normal, la valeur de mot stockée dans la mémoire est transférée par le circuit logique au convertisseur numérique-analogique.

4. Circuit de synchronisation de ligne selon la revendication 2, caractérisé en ce que le circuit logique a une fonction de comptage au cours du procédé d'ajustement initial.

5. Circuit de synchronisation de ligne selon la revendication 2, caractérisé en ce que mémoire est une E²PROM.